(19) Europäisches Patentamt / European Patent Office / Office européen des brevets

(11) **EP 4 336 240 B1**

(12) **EUROPEAN PATENT SPECIFICATION**

(45) Date of publication and mention of the grant of the patent:
**30.07.2025   Bulletin 2025/31**

(21) Application number: **22820094.5**

(22) Date of filing: **31.05.2022**

(51) International Patent Classification (IPC):
**G02B 26/10** (2006.01)    **B81B 3/00** (2006.01)
**G02B 26/08** (2006.01)

(52) Cooperative Patent Classification (CPC):
**B81B 3/0086; G02B 26/08; G02B 26/0841;
G02B 26/10;** B81B 2201/042; B81B 2203/0136;
B81B 2203/0353

(86) International application number:
**PCT/JP2022/022091**

(87) International publication number:
**WO 2022/259912 (15.12.2022 Gazette 2022/50)**

(54) **OPTICAL SCANNING DEVICE AND ELECTRONIC APPARATUS**

OPTISCHE ABTASTVORRICHTUNG UND ELEKTRONISCHE VORRICHTUNG

DISPOSITIF DE BALAYAGE OPTIQUE ET APPAREIL ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:   **10.06.2021   JP 2021097540**

(43) Date of publication of application:
**13.03.2024   Bulletin 2024/11**

(73) Proprietor: **Stanley Electric Co. Ltd.
Tokyo 153-8636 (JP)**

(72) Inventor: **ODA, Yutaro
Tokyo 153-8636 (JP)**

(74) Representative: **Pritzlaff, Stefanie Lydia
Wagner & Geyer Partnerschaft mbB
Patent- und Rechtsanwälte
Gewürzmühlstraße 5
80538 München (DE)**

(56) References cited:
JP-A- 2004 245 890    JP-A- 2004 245 890
JP-A- 2017 058 418    JP-A- 2017 058 418
JP-B2- 3 011 144    US-A1- 2022 066 197

## Description

### TECHNICAL FIELD

The present disclosure relates to an optical scanning apparatus and an electronic equipment.

### BACKGROUND ART

There is known an optical scanning apparatus that scans incident laser beam in a two-dimensional direction. A prior art example of an optical scanning apparatus is disclosed in, for example, the following Patent Document 1 and the Non-Patent Document 1. In such an optical scanning apparatus, it is necessary to detect the deflection angle of a movable mirror that scans the laser beam, but noise is likely to be mixed into the signal used in the process.

### PRIOR ART DOCUMENT

### PATENT DOCUMENT

[Patent Document 1] Japanese Patent Application Laid-Open No. 2004-245890
[Non-patent Document 1] Hee-Moon Jeong et al., "Slow scanning electromagnetic MEMS scanner for laser display", Proc.SPIE6887, MOEMS and Maniaturized Systems VII, 688704 (8 February 2008). Documents JP 2017 058418 A, and JP 3 011144 B2 are further pieces of relevant prior art.

### SUMMARY OF THE INVENTION

### TECHNICAL PROBLEM

In a specific aspect, it is an object of the present disclosure to reduce noise of the signal used to detect the deflection angle of a movable mirror.

### SOLUTION TO THE PROBLEM

(1) An optical scanning apparatus according to one aspect of the present disclosure is an optical scanning apparatus including: (a) a mirror having a reflective surface; (b) a driving section that swings the mirror; (c) a detection section that detects the movement of the driving section by change of a capacitance; and (d) a dummy capacitance section that generates a dummy capacitance that is approximately equivalent to the capacitance in an initial state of the detection section; (e) where the detection section has a movable electrode whose position changes in relation to the movement of the driving section and a fixed electrode whose position does not change in relation to the movement of the driving section, and is configured such that the capacitance is generated between the movable electrode and the fixed electrode, (f) where the dummy capacitance section is configured to include a first electrode and a second electrode, and is configured to generate the dummy capacitance between the first electrode and the second electrode, (g) where the movable electrode, the fixed electrode, the first electrode, and the second electrode are provided in an active layer formed in the same semiconductor layer, and are each separated, and where the active layer is arranged to face a support layer which is a common semiconductor layer, with an insulating layer in between, (h) where a first parasitic capacitance that occurs between the active layer provided with the fixed electrode and the supporting layer, and a second parasitic capacitance that occurs between the active layer provided with the first electrode and the supporting layer, are approximately equivalent, and (i) where the capacitance of the detection section and the first parasitic capacitance are connected in series to form a first signal path, and the dummy capacitance and the second parasitic capacitance are connected in series to form a second signal path.
(2) An electronic equipment according to one aspect of the present disclosure is an electronic equipment including the optical scanning apparatus according to the above-described (1).

According to the above configurations, it is possible to reduce noise of the signal used to detect the deflection angle of a movable mirror.

### BRIEF DESCRIPTION OF THE DRAWINGS

FIG. 1 is a plane view showing the configuration of an optical scanning apparatus (optical deflector) according to a first embodiment.
FIG. 2A is an enlarged view of a deflection angle detection section.
FIG. 2B is an enlarged view of a dummy comb teeth structure section.
FIG. 3A is an enlarged view of a detection pad.
FIG. 3B is an enlarged view of a dummy detection pad.
FIG. 4 is an enlarged plane view of the vicinity of a read signal input pad.
FIG. 5 is a schematic cross-sectional view corresponding to the a-a line direction shown in FIG. 1.
FIG. 6 is a diagram for explaining the portion in which parasitic capacitance is generated.
FIG. 7 is a plane view for explaining capacitance components formed in each portion of the optical scanning apparatus.

FIG. 8A is a cross-sectional view showing the connection relationship of locations forming capacitance components in the optical scanning apparatus.

FIG. 8B is an equivalent circuit diagram showing the connection relationship of each capacitance component.

FIG. 9A is a waveform diagram showing an example of a read signal.

FIG. 9B is a waveform diagram showing an example of a voltage signal $V_{out1}$.

FIG. 9C is a waveform diagram showing an example of a voltage signal $V_{out2}$.

FIG. 9D is an enlarged waveform diagram showing an example of a differential signal between voltage signals $V_{out1}$ and $V_{out2}$.

FIGs. 10A to 10G are process diagrams showing an example of a method for manufacturing an optical scanning apparatus.

FIGs. 11A to 11F are process diagrams showing an example of a method for manufacturing an optical scanning apparatus.

FIG. 12 is a plane view showing the configuration of an optical scanning apparatus according to a second embodiment.

FIG. 13 is a partial enlarged view of the optical scanning apparatus shown in FIG. 12.

FIG. 14 is a partial enlarged view of the optical scanning apparatus shown in FIG. 12.

FIGs. 15A and 15B are partial cross-sectional views of the optical scanning apparatus of a second embodiment.

## MODE FOR CARRYING OUT THE INVENTION

(First embodiment)

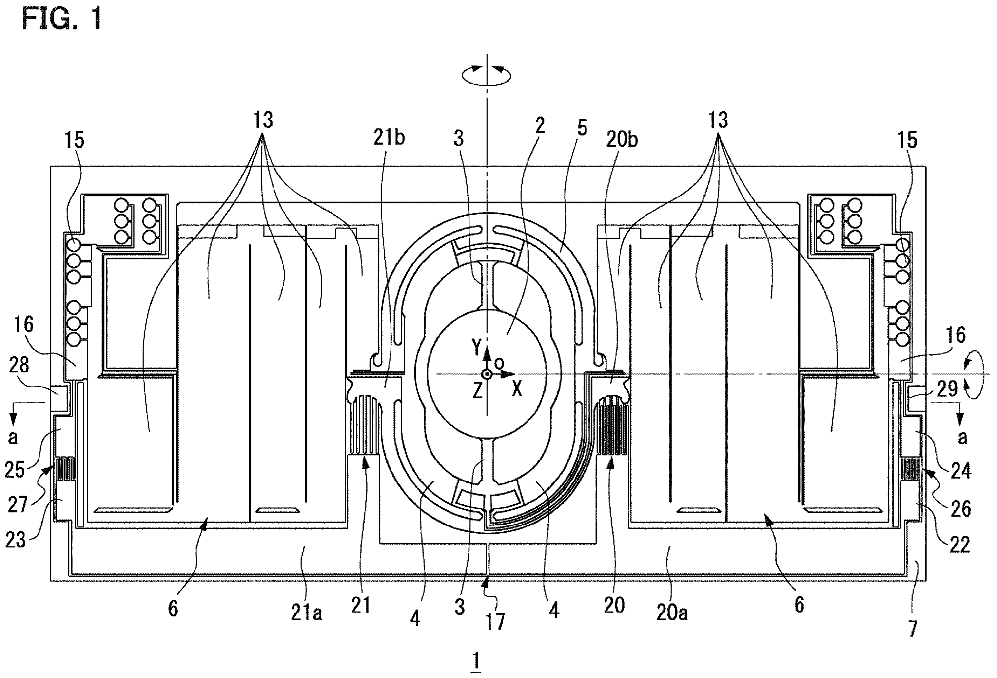

FIG. 1 is a plane view showing the configuration of an optical scanning apparatus (optical deflector) 1 according to a first embodiment. In the present embodiment, the surface into which the laser beam to be scanned enters is defined as the front surface, and the surface on the opposite side thereof is defined as the back surface. FIG. 1 shows a plane view seen from the front surface side. As illustrated, the optical scanning apparatus 1 of the present embodiment has an almost bilaterally symmetrical structure in a plane view.

The optical scanning apparatus 1 is configured to include a reflecting section (mirror) 2, a torsion bar 3, inner piezoelectric actuators 4, an inner frame section 5, outer piezoelectric actuators (drive sections) 6, and an outer frame section (frame) 7 as a main component. The horizontal direction in the figure is defined as the X axis, the vertical direction as the Y axis, and the thickness direction of the optical scanning apparatus 1 (direction perpendicular to the diagram sheet surface) as the Z axis.

The reflecting section 2 is a movable mirror having a substantially circular reflecting surface in a plane view, and is configured to be swingable around the Y-axis and the X-axis by the inner piezoelectric actuators 4 and the outer piezoelectric actuators 6. By reflecting a laser beam by such reflecting section 2, the laser beam incident on the reflecting section 2 can be scanned in a two-dimensional direction.

The torsion bar 3 is provided, in a plane view, above and below the reflecting section 2. The torsion bar 3 extends along the Y-axis direction from the reflecting section 2 and is coupled to the inner periphery of the inner frame section 5. Further, the torsion bar 3 is coupled to the upper and lower ends of the left and right inner piezoelectric actuators 4.

The inner piezoelectric actuators 4 and the outer piezoelectric actuators 6 are provided one each on the left and right sides of the reflecting section 2 in a plane view.

The inner piezoelectric actuators 4 are coupled to each other, and have an overall shape close to an ellipse that extends along the Y-axis in a plane view.

The outer piezoelectric actuators 6 are interposed between the inner frame section 5 and the outer frame section 7. Each of the outer piezoelectric actuators 6 is configured to include a plurality of piezoelectric cantilevers 13. Among the piezoelectric cantilevers 13, the one closest to the reflecting section 2 and the one farthest from the reflecting section 2 have shorter lengths in the Y-axis direction than the other piezoelectric cantilevers 13. Further, each piezoelectric cantilever 13 has a width in the X-axis direction that becomes relatively small as it is located closer to the reflecting section 2.

The inner frame section 5 surrounds the reflecting section 2 and the torsion bar 3. The inner frame section 5 has an overall shape close to an ellipse that extends along the Y-axis in a plane view.

A driving pad 15 and a driving GND pad 16 are respectively provided on the left and right upper sides of the outer frame section 7 in a plane view. The driving pad 15 has a plurality of circular portions in a plane view. The driving pad 15 and the driving GND pad 16 are electrically/physically connected to the outside via bonding wires (not shown) when the optical scanning apparatus 1 is packaged.

The driving pad 15 and the driving GND pad 16 on the right side in the figure are used to supply a drive voltage to the inner piezoelectric actuator 4 on the right side in the figure. Similarly, the driving pad 15 and the driving GND pad 16 on the left side in the figure are used to supply a drive voltage to the inner piezoelectric actuator 4 on the left side in the figure. Each inner piezoelectric actuator 4 is interposed between the torsion bar 3 and the inner frame section 5, and oscillates the reflecting section 2 around the Y axis at a first frequency by twisting the torsion bar 3. Resonance is used for this oscillation. The first frequency is, for example, 15kHz to 25kHz.

Each outer piezoelectric actuator 6 is supplied with a drive voltage of a second frequency via the driving pad 15 and the driving GND pad 16. Thereby, the reflecting section 2 oscillates around the X-axis at the second frequency. Resonance is not used for the oscillation around the X-axis. The second frequency is lower than the first frequency described above, and is set to, for example, 60 Hz.

Laser beam that enters the reflecting section 2 from a light source (not shown) is reflected in a direction according to the swing angle (deflection angle) of the reflecting section 2 around the X-axis and the Y-axis. The reflecting direction (deflecting direction) changes moment by moment according to changes in the swing angle of the reflection section 2. Thereby, the laser beam reflected by the reflection section 2 is scanned around the Y-axis at the first frequency and scanned around the X-axis at the second frequency.

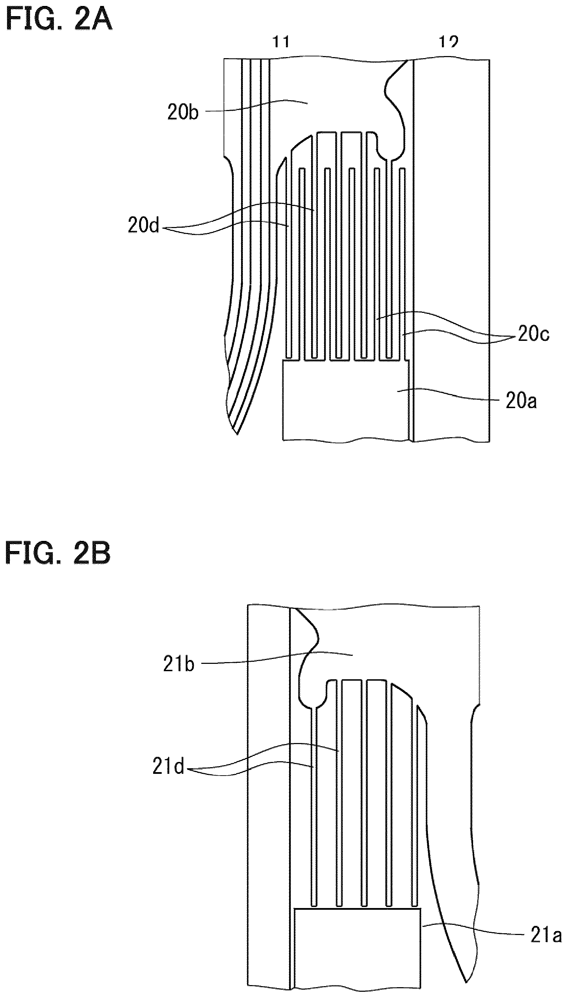

A deflection angle detection section (a detection section) 20 is for detecting the deflection angle of the reflection section 2 by detecting the movement accompanying non-resonant vibration by the outer piezoelectric actuators 6 as a change of a capacitance, and is configured to include a fixed electrode 20a and a movable electrode 20b. The fixed electrode 20a is configured integrally with the outer frame section 7. This fixed electrode 20a has a comb teeth electrode 20c, as shown in an enlarged view in FIG. 2A. The movable electrode 20b has a comb teeth electrode 20d, as shown in an enlarged view in FIG. 2A. The comb teeth electrode 20c and the comb teeth electrode 20d are arranged so that each other's electrode branches form a line one by one in turn along the X-axis direction. The position of the comb teeth electrode 20c of the fixed electrode 20a does not change regardless of the movement of the outer piezoelectric actuators 6, and the position of the comb teeth electrode 20d of the movable electrode 20b changes in relation to the movement of the outer piezoelectric actuators 6. A capacitance component (capacitance) is formed between the comb teeth electrode 20c and the comb teeth electrode 20d, and its magnitude changes in accordance with the positional change of the comb teeth electrode 20d.

A dummy comb teeth structure section 21 is a portion provided in a pair with the deflection angle detection section 20, and is configured to include a fixed electrode 21a and a movable electrode 21b. The fixed electrode 21a is configured integrally with the outer frame section 7. The movable electrode 21b has a comb teeth electrode 21d, as shown in an enlarged view of FIG. 2B. In the dummy comb teeth structure section 21, the fixed electrode 21a is not provided with a comb teeth electrode. Therefore, no capacitance component is formed in the dummy comb teeth structure section 21. The dummy comb teeth structure section 21 is provided to balance the weight between the left and right outer piezoelectric actuators 6.

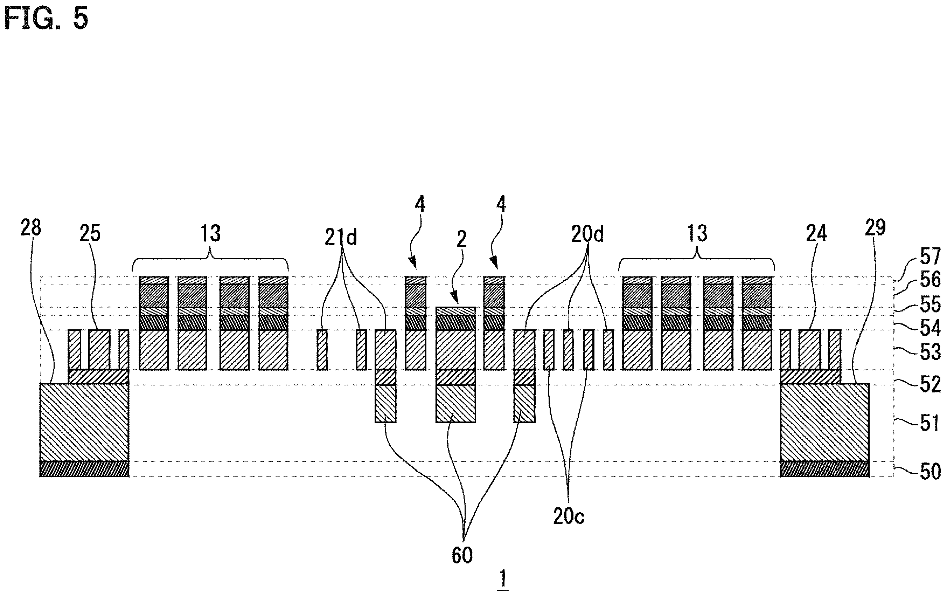

The dummy comb teeth structure section 21 and the deflection angle detection section 20 are electrically and physically separated from each other by a groove 17 provided between the respective fixed electrodes 20a and 21a, at a Si layer 53 which is an active layer (refer to FIG. 5, which will be described later). The groove 17 reaches a SiO$_2$ layer 52 and is electrically and physically separated from the SiO$_2$ layer 52.

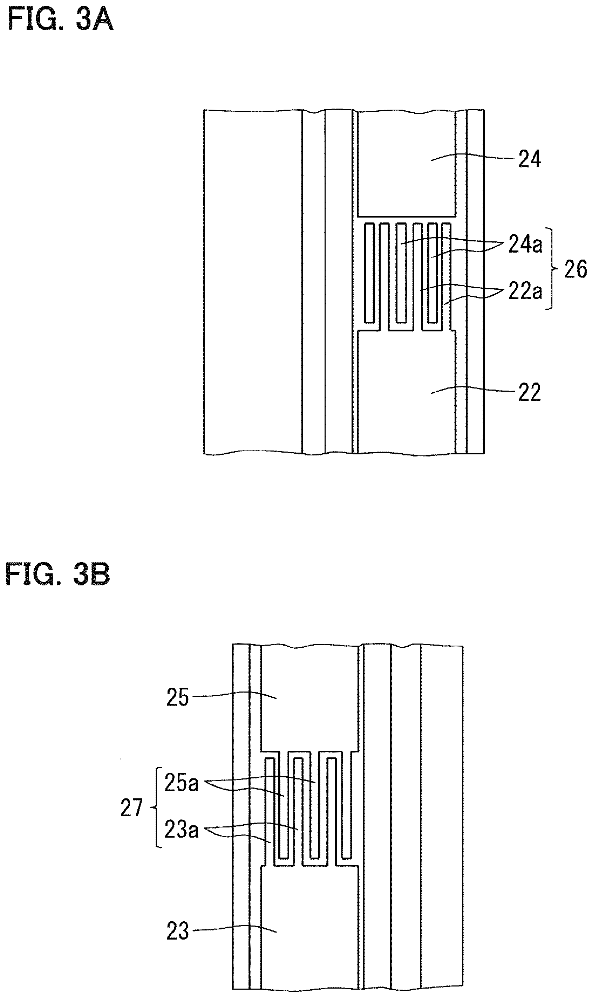

A detection pad 22 is connected to the fixed electrode 20a and is arranged at the lower right end in the figure. A detection GND pad 24 is arranged above the detection pad 22 in the figure. As shown in an enlarged view in FIG. 3A, the detection pad 22 has a comb teeth electrode 22a. Further, an island-shaped dummy electrode branch 24a is provided between the respective electrode branches of the comb teeth electrode 22a. The dummy electrode branches 24a are not connected to the detection GND pad 24, etc., and are separated into island shapes. A comb teeth structure section 26 is configured by the comb teeth electrode 22a and each dummy electrode branch 24a. This comb teeth structure section 26 is a part to maintain a balance with the dummy detection section 27 and to equalize the etching area. The detection GND pad 24, the comb teeth electrode 22a, and the dummy electrode branch 24a are electrically and physically separated from each other by the groove 17 at the Si layer 53.

A dummy detection pad 23 is connected to the fixed electrode 21a and is arranged at the lower left end in the figure. A detection GND pad 25 is arranged above the dummy detection pad 23 in the figure. As shown in an enlarged view in FIG. 3B, a comb teeth electrode (first electrode) 23a is connected to the dummy detection pad 23, and a comb teeth electrode (second electrode) 25a is connected to the detection GND pad 25, and a dummy detection section (a dummy capacitance section) 27 is configured by these comb teeth electrodes 23a and 25a. The comb teeth electrodes 23a and 25a are electrically and physically separated from each other by the groove 17 at the Si layer 53. The size of the capacitance component (dummy capacitance) formed by the dummy detection section 27 is designed so that it becomes approximately equivalent to the capacitance component formed by the comb teeth electrode 20c and the comb teeth electrode 20d of the deflection angle detection section 20 in the initial state. Here, note that the initial state refers to a state in which the outer piezoelectric actuator 6 does not fluctuate. The dummy detection section 27 is formed in the outer frame section 7 so that the capacitance component does not change due to the deflection angle.

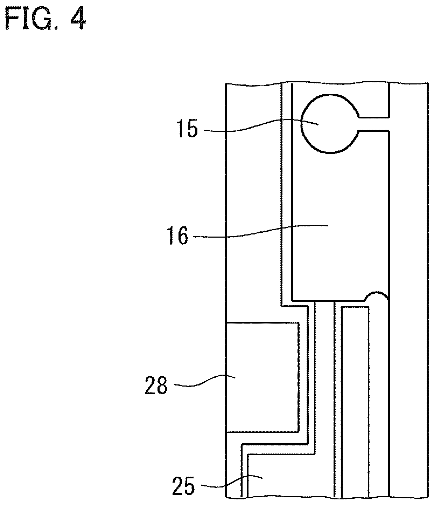

A read signal input pad 28 is arranged above the detection GND pad 25 on the left end side in the figure. A read signal input pad 29 is arranged above the detection GND pad 24 on the right end side in the figure. These read signal input pads 28 and 29 are used to input signals (read signals) used for reading the deflection angle. FIG. 4 shows an enlarged plane view of the vicinity of the read signal input pad 28. Here, note that although an enlarged view is omitted, the read signal input pad 29 has a similar structure.

FIG. 5 is a schematic cross-sectional view corresponding to the a-a line direction shown in FIG. 1. Here, note that in FIG. 5, the structure of the optical scanning apparatus 1 is illustrated in a modified manner in order to make it easier to understand the laminated structure and the configuration of each section. The optical scanning apparatus 1 of the present embodiment has a basic structure in which the $SiO_2$ (silicon dioxide) layer 52 as an etching stop layer on one side (upper side in the figure) of the Si (silicon) layer 51 as a support layer to retain the reflective section 2, etc. is provided, and in which the Si layer 53 as an active layer for forming elements is provided thereon.

Specifically, the optical scanning apparatus 1 is configured to include, in order from the bottom in the figure, a $SiO_2$ layer 50 as an insulating layer, the Si layer 51 as a support layer that holds the element, the $SiO_2$ layer (box layer) 52 as an etching stop layer, the Si layer 53 as an active layer for forming an element, a $SiO_2$ layer 54 as an insulating layer to insulate from the piezoelectric driving section on the upper layer side, a Pt (platinum) layer 55 as a lower electrode layer, a PZT (lead zirconate titanate) layer 56 as a piezoelectric layer, and a Pt layer 57 as an upper electrode layer. Each of these layers is patterned into a predetermined shape.

As shown in the figure, based on a reinforcing rib layer 60 formed by etching the Si layer 51 halfway, the reflective section 2 is configured by laminating the $SiO_2$ layer 52, the Si layer 53, the $SiO_2$ layer 54, and the Pt layer 55.

The left and right inner piezoelectric actuators 4 as a resonance driving section is configured by laminating the Si layer 53, the $SiO_2$ layer 54, the Pt layer 55, the PZT layer 56, and the Pt layer 57. Similarly, each piezoelectric cantilever 13 of the left and right outer piezoelectric actuators 6 as a non-resonant driving section is configured by laminating the Si layer 53, the $SiO_2$ layer 54, the Pt layer 55, the PZT layer 56, and the Pt layer 57.

The fixed electrode 20a and its comb teeth electrode 20c, and the movable electrode 20b and its comb teeth electrode 20d, which constitute the deflection angle detection section 20, are each composed of the Si layer 53. That is, the fixed electrode 20a and the movable electrode 20b are formed in the same semiconductor layer. Thereby, the Si layer 51 as a support layer can be used as a base of the element. The comb teeth electrode 20d of the movable electrode 20b is connected to the detection GND pad 24 through the Si layer 53 surrounded by a groove. The comb teeth electrode 20c of the fixed electrode 20a is integrated with the outer frame section 7.

Similarly, the comb teeth electrode 21d that constitutes the dummy comb teeth structure section 21 is composed of the Si layer 53.

The left and right detection GND pads 24 and 25 are provided on the Si layer 53 which is stacked on the $SiO_2$ layer 50, the Si layer 51, and the $SiO_2$ layer 52. Further, each of the left and right signal reading signal input pads 28 and 29 is configured to expose the Si layer 51 on the same side as the reflective surface of the reflective section 2 by etching up to the $SiO_2$ layer 52

on the Si layer 51 as a support layer. This allows electrical connection to the Si layer 51 from the upper surface side of the optical scanning apparatus 1 (the side on which the laser beam is incident).

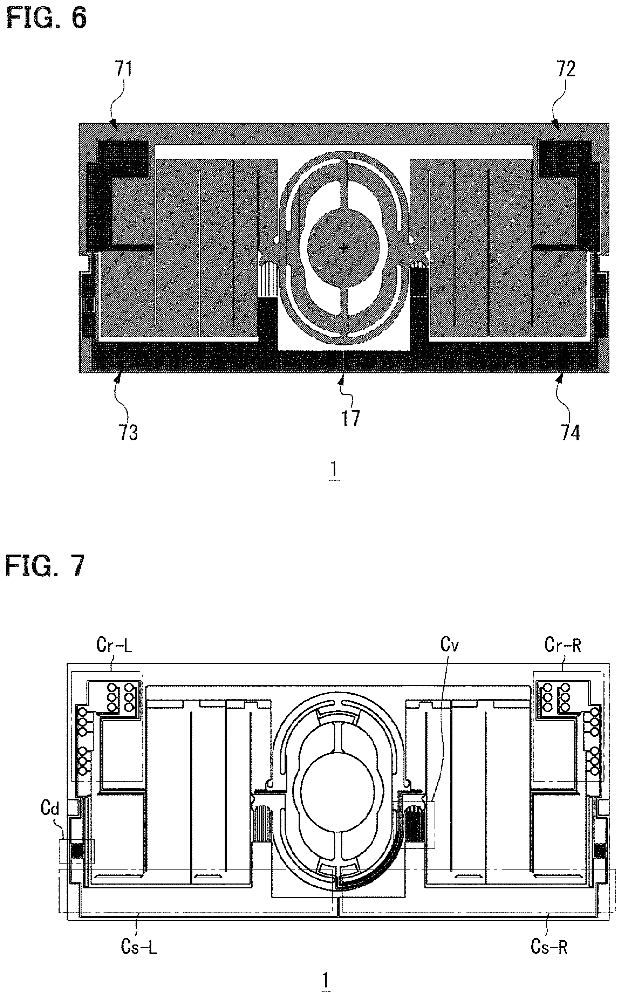

FIG. 6 is a diagram for explaining the portion in which parasitic capacitance is generated. In FIG. 6, a plane view of the optical scanning apparatus 1 viewed from the back side is shown, and four portions 71, 72, 73, and 74 where parasitic capacitance is generated are shown in dark gray. Since the optical scanning apparatus 1 of the present embodiment uses an SOI (Silicon on Insulator) structure as shown in FIG. 5, at a portion where the Si layer 51 which is a support layer and the Si layer 53 which is an active layer overlap, an $SiO_2$ layer 52 is sandwiched between each layer, thereby parasitic capacitance is formed. The portions 71 and 72 correspond to regions in which the driving pad 15, the driving GND pad 16, etc. are formed, respectively. The portions 73 and 74 correspond to regions in which the fixed electrodes 20a and 21a are formed, respectively. The portion 73 and the portion 74 are separated by the groove 17 described above.

FIG. 7 is a plane view for explaining capacitance components formed in each portion of the optical scanning apparatus. FIG. 7 is a scaled-down version of the plane view shown in FIG. 1, and shows locations where capacitance components are formed. The capacitance component corresponding to the formation region of the driving pad 15, driving GND pad 16, etc. on the upper left side in the figure is defined as $C_{r-L}$. The capacitance component corresponding to the formation region of the driving pad 15, driving GND pad 16, etc. on the upper right side of the figure is defined as $C_{r-R}$. Further, the capacitance components (first parasitic capacitance, second parasitic capacitance) corresponding to the formation regions of fixed electrodes 20a, 21a, etc. are defined as $C_{s-L}$ and $C_{s-R}$, respectively. Further, the capacitance component formed at the deflection angle detection section 20 (capacitance of the detection section) is defined as $C_V$. The capacitance component (dummy capacitance) formed at the dummy detection section 27 is defined as $C_d$.

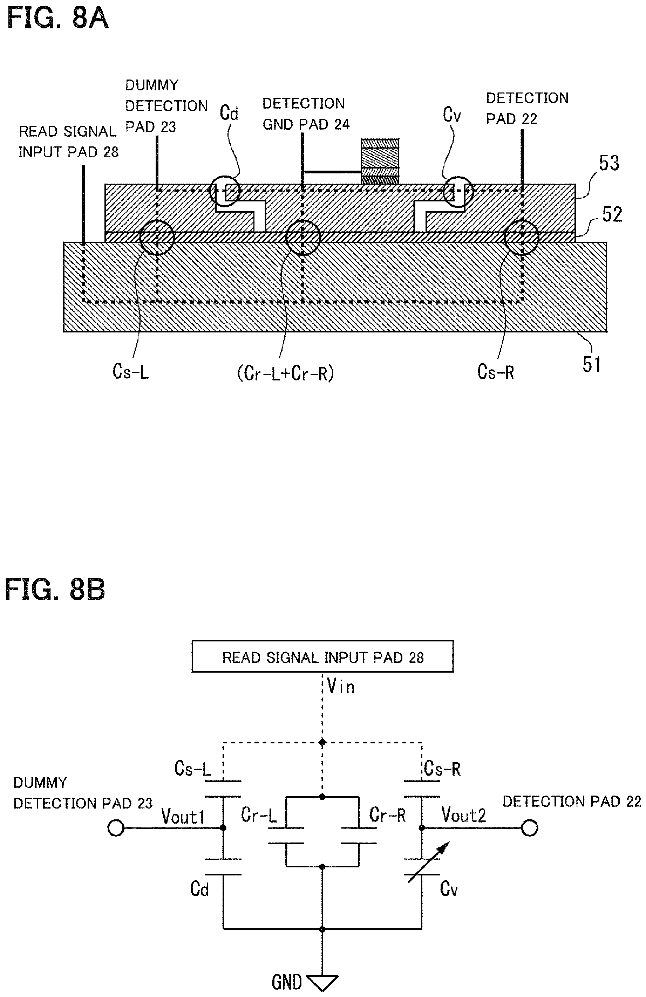

FIG. 8A is a cross-sectional view showing the connection relationship of locations forming capacitance components in the optical scanning apparatus. Here, for ease of understanding, portions related to capacitance components are shown in a modified manner. As shown in the figure, the capacitance component $C_{s-L}$ is formed on a signal path leading from the Si layer 51 which is a support layer, to the dummy detection pad 23. The capacitance component $C_{s-R}$ is formed on a signal path leading from the Si layer 51 which is a support layer, to the detection pad 22. The capacitance component $C_{r-L}$ and the capacitance component $C_{r-R}$ are each formed on a signal path leading from the Si layer 51 which is a support layer, to the detection GND pad 24. Further, the capacitance component (dummy capacitance) $C_d$ is formed in the dummy detection section 27 and is connected to the detection GND pad 24 (i.e., GND potential). Further, the capacitance component (detection capacitance) $C_v$ is formed at the deflection angle detection section 20 and is connected to the detection GND pad 24 (i.e., GND potential).

FIG. 8B is an equivalent circuit diagram showing the connection relationship of each capacitance component. As shown, the capacitance component $C_{s-L}$ and the capacitance component $C_d$ are connected in series, the capacitance component $C_{s-R}$ and the capacitance component $C_v$ are connected in series, and these are connected in parallel. Further, the capacitance components $C_{r-R}$ and $C_{r-L}$ are connected in parallel to these signal paths (first signal path, second signal path), respectively. Here, note that in the figure, circuit connection lines indicated by solid lines represent connections through the Si layer 53 which is an active layer, and circuit connection lines indicated by dotted lines represent connections through the Si layer 51 which is a support layer.

A read signal input from the read signal input pad 28 is input in parallel to each capacitance component $C_{s-L}$, $C_{s-R}$, $C_{r-R}$, and $C_{r-L}$ via the Si layer 51, which is a support layer. The read signal passing through each capacitance component $C_{r-R}$ and $C_{r-L}$ reaches the GND potential as it is, but the read signal passing through each capacitance component $C_{s-L}$ and $C_{s-R}$ reaches the GND potential via each capacitance component $C_d$ and $C_v$.

From the dummy detection pad 23, a voltage signal $V_{out1}$ which is divided by the capacitance component $C_{s-L}$ and the capacitance component $C_d$, is obtained. From the detection pad 22, a voltage signal $V_{out2}$ which is divided by the capacitance component $C_{s-R}$ and the capacitance component $C_v$, is obtained. Therefore, by obtaining the difference between these voltage signals $V_{out1}$ and $V_{out2}$, it is possible to obtain a signal in which a common in-phase noise components are canceled. Thus, this improves the accuracy of deflection angle detection. Further, since there is no need to add a new layer as a support layer (foundation), cost increase can be suppressed.

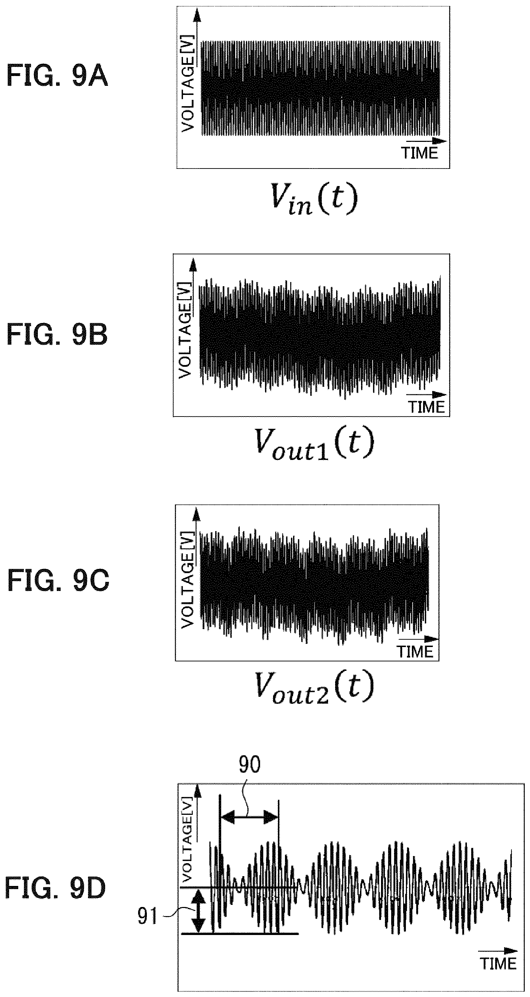

FIG. 9A is a waveform diagram showing an example of the read signal, FIG. 9B is a waveform diagram showing an example of the voltage signal $V_{out1}$, FIG. 9C is a waveform diagram showing an example of the voltage signal $V_{out2}$, and FIG. 9D is an enlarged waveform diagram showing an example of a differential signal between voltage signals $V_{out1}$ and $V_{out2}$. Here, when defining a read signal which is an input voltage at a certain time "t" as $V_{in}(t)$, noise as N(t), and a differential signal between the voltage signals $V_{out1}(t)$ and $V_{out2}(t)$ as v(t), these parameters can be expressed as follows.

$$V_{out1}(t) = V_{in}(t) + N(t)$$

$$V_{out2}(t) = V_{in}(t) + v(t) + N(t)$$

$$V_{out2}(t) - V_{out1}(t) = v(t)$$

When the deflection angle detection section 20 is at the initial position, the capacitance component $C_v$ and the capacitance component $C_d$ are approximately equal and the equivalent circuit is symmetrical, therefore, the voltage signal $V_{out1}$ and the voltage signal $V_{out2}$ are theoretically equal. Considering a case where the deflection angle detection section 20 operates and the capacitance component $C_v$ decreases, that is, a case where the impedance increases, the voltage signal $V_{out2}$ increases relative to the voltage signal $V_{out1}$ based on Voltage Division Rule. The opposite phenomenon occurs when the capacitance component $C_v$ increases. Therefore, by obtaining the difference between the voltage signal $V_{out1}$ and the voltage signal $V_{out2}$, the common noise component is canceled out, and the change in voltage due to the deflection angle detection section 20 can be detected. In detail, as shown in FIG. 9D, since the capacitance component $C_v$ changes according to the frequency of the outer piezoelectric actuator 6, which is a non-resonant driving section, the impedance also changes periodically, and accordingly, the voltage signal $V_{out2}$ also changes periodically. Since there are two points where the capacitance is maximum per period, the fluctuation cycle 90 of the differential signal is twice the driving frequency. Further, a change amount 91 of the differential signal corresponds to a change amount of the deflection angle.

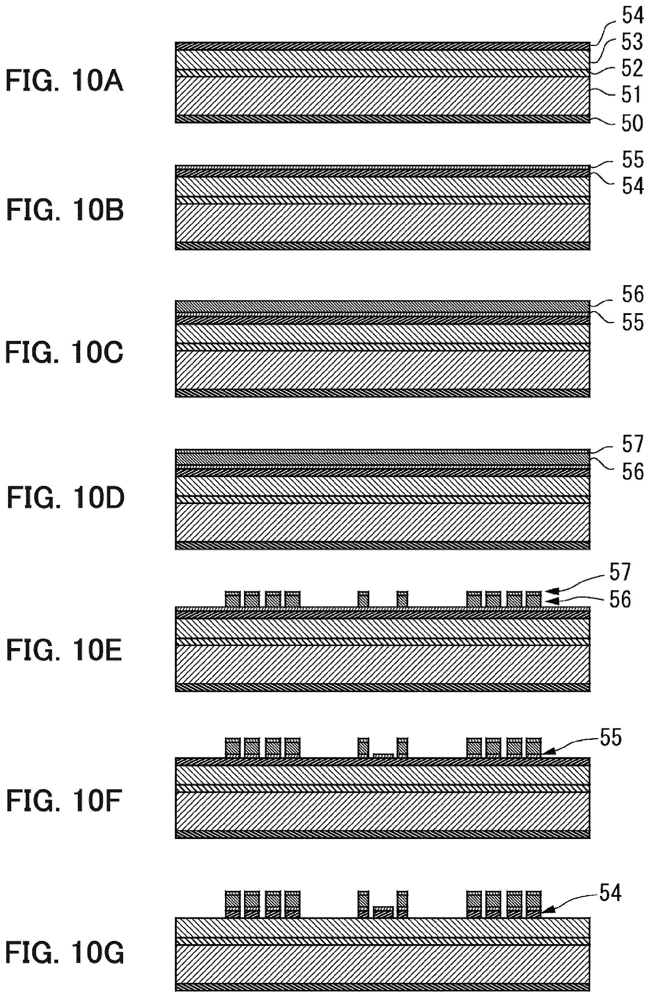

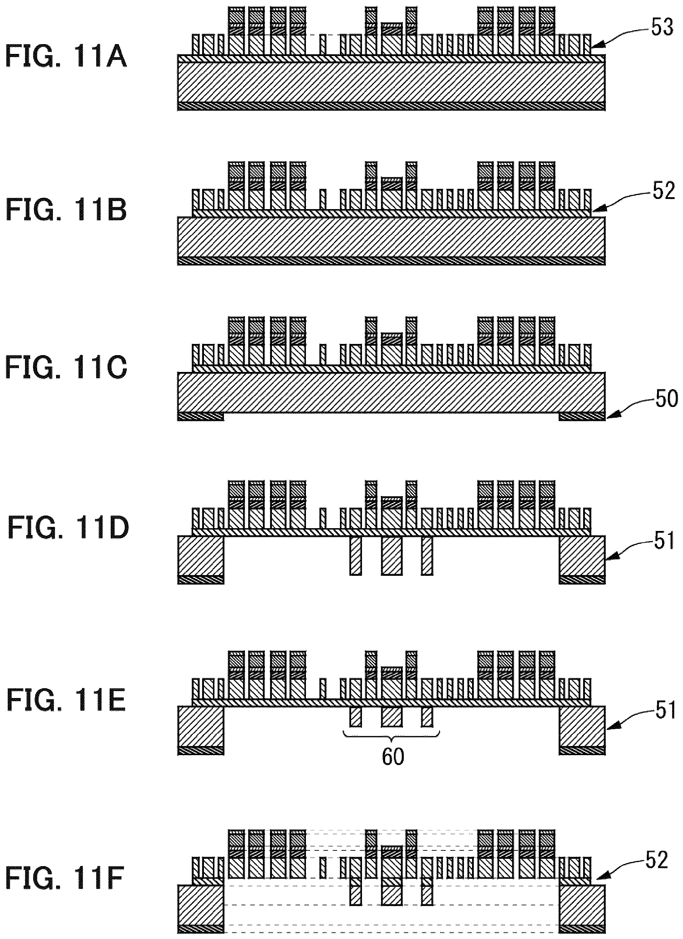

FIGs. 10A to 10G and FIGs. 11A to 11F are process diagrams showing an example of a method for manufacturing the optical scanning apparatus. Hereinafter, an example of a method for manufacturing the optical scanning apparatus 1 will be briefly described with reference to each figure.

First, a substrate in which the $SiO_2$ layer 50, the Si layer 51, the $SiO_2$ layer 52, the Si layer 53, and the $SiO_2$ layer 54 are stacked is prepared (FIG. 10A), and a Pt layer 55 is formed on one side of the $SiO_2$ layer 54 (the side not in contact with the Si layer 53) (FIG. 10B). Next, a PZT layer 56 is formed on one side of the Pt layer 55 (the side not in contact with the $SiO_2$ layer 54) (FIG. 10C), and further, a Pt layer 57 is formed on one side of the PZT layer 56 (the side not in contact with the Pt layer 55) (FIG. 10D). Here, note that any known method may be used for the film formation method.

Next, the Pt layer 57 and the PZT layer 56 are patterned into a predetermined shape (FIG. 10E). Here, any known method may be used for this patterning. As an example, in the present embodiment, a method is used in which a mask pattern is formed using a resist film (photoresist film), etching is performed, and then the resist film is peeled off (the same applies to the patterning in each subsequent step).

Next, the Pt layer 55 is patterned into a predetermined shape (FIG. 10F), and then the $SiO_2$ layer 54 is patterned into a predetermined shape (FIG. 10G). Further, the Si layer 53 is patterned into a predetermined shape (FIG. 11A), and then the SiO₂ layer 52 is patterned into a predetermined shape (FIG. 11B).

Next, the SiO₂ layer 50 on the back surface side is patterned into a predetermined shape (FIG. 11C). Then the Si layer 51 is patterned into a predetermined shape (FIG. 11D), and the rib portion 60 is further formed (FIG. 11E). Thereafter, the SiO₂ layer 52 is patterned into a predetermined shape (FIG. 11F). Through the above steps, the optical scanning apparatus 1 according to the embodiment described above is completed.

According to the first embodiment as described above, it is possible to reduce noise of the signal used to detect the deflection angle of the movable mirror.

The optical scanning apparatus 1 according to the first embodiment described above can be applied to any electronic equipment that requires laser beam scanning. For example, it can be applied to pico-projectors used in head-up displays and wearable devices. Further, the present disclosure can be applied to an apparatus that changes the light distribution pattern depending on the presence of an oncoming vehicle, a preceding vehicle, a pedestrian, or various objects when irradiating light toward the front of an own vehicle. Alternatively, the present disclosure can be applied to an object detection apparatus such as LiDAR (Light Detection And Ranging). Further, the present disclosure can be applied to various MEMS sensors such as an acceleration sensor, an angular velocity sensor, a pressure sensors, or a myoelectric sensor.

(Second embodiment)

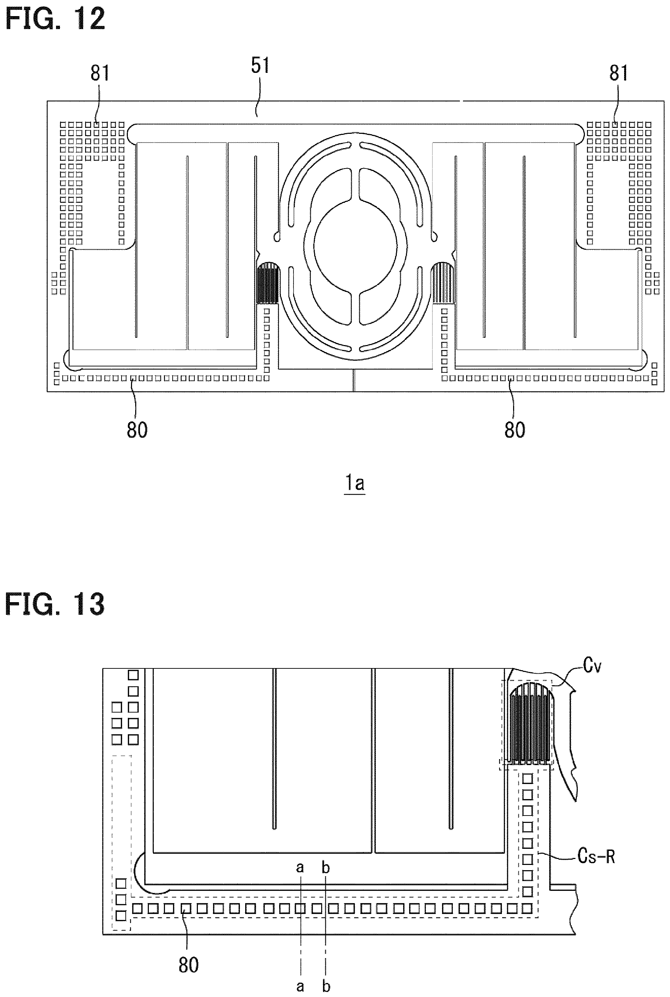

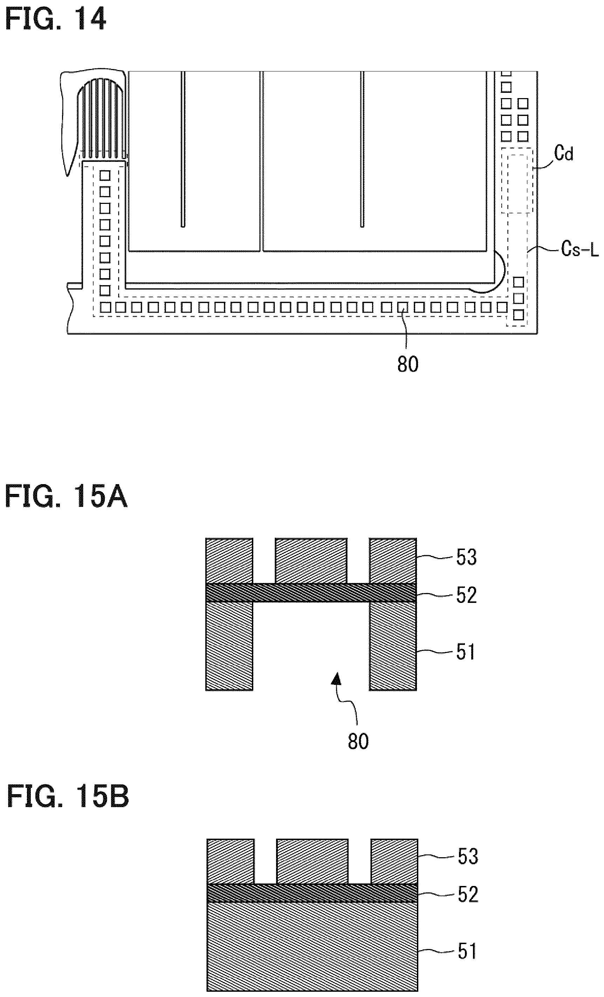

FIG. 12 is a plane view from the back side of an optical scanning apparatus according to a second embodiment. Further, FIGs. 13 and 14 are partial enlarged views of the optical scanning apparatus shown in FIG. 12, respectively. Here, note that the overall configuration of the optical scanning apparatus 1a according to the second embodiment is the same as the optical scanning apparatus 1 according to the first embodiment described above, and only the structure of the Si layer 51 which is a support layer is different. Hereinafter, regarding the optical scanning apparatus 1a according to the second embodiment, the description of common features with the optical scanning apparatus 1 of the first embodiment will be omitted, and the structure of the Si layer 51 which is different, will be described in detail.

As shown in the figure, the Si layer 51 of the optical scanning apparatus 1a is provided with a plurality of through holes 80 in a region overlapping with the Si layer 53 (that is, a portion related to the generation of parasitic capacitance), where the Si layer 53 which is an active layer that comprises capacitance component $C_{s-L}$ and capacitance component $C_{s-R}$ that are capacitance components corresponding to the formation regions of fixed electrodes 20a, 21a, etc. In the illustrated example, the through holes 80 are arranged in rows in the horizontal and vertical directions in the figure, but the arrangement of the through holes 80 is not limited thereto. The region where each through hole 80 is arranged corresponds to the above-described portions 73 and 74 (refer to FIG. 6). Further, a plurality of through holes 81 are similarly provided in the portions 71 and 72 described above, that is, in the regions where the driving pad 15 and the driving GND pad 16 are formed. With regard to the size of each of the through holes 80 and 81, for example, when each is approximately square as shown in the figure, one side thereof can be approximately 50 μm to 150 μm.

FIGs. 15A and 15B are partial cross-sectional views of the optical scanning apparatus of the second embodiment. FIG. 15A is a cross-sectional view taken along line a-a shown in FIG. 13, and FIG. 15B is a cross-sectional view taken along line b-b shown in FIG. 13. As shown in FIG. 15A, the through hole 80 is formed by partially removing the Si layer 51 which is a support layer, to reach the SiO₂ layer (BOX layer) 52. On the other hand, as shown in FIG. 15B, at the portion where the through hole 80 does not exist, the Si layer 51 which is a support layer is not removed, and the SiO₂ layer (BOX layer) 52 is not exposed. Here, although not shown, each through hole 81 has a similar structure as the through hole 80. These through holes 80 and 81 can be formed during the process of etching the Si layer 51 (refer to FIG. 11E) in the manufacturing process of the optical scanning apparatus 1 described in the first embodiment. Since the Si layer 51 which is a support layer also has a role of ensuring mechanical strength of the optical scanning apparatus 1a, by only partially removing the layer to form the through holes 80 and 81, a decrease in mechanical strength can be prevented.

By providing each through hole 80, it is possible to reduce the overlapping area between the Si layer 51 which is a support layer, and the Si layer 53 which is an active layer. Thereby, the values of the capacitance component $C_{s-L}$ and the capacitance component $C_{s-R}$, which are parasitic capacitance, can be reduced. This reduces the difference between the capacitance component $C_V$ which is the capacitance component to be detected and the capacitance component $C_{s-R}$. Thereby, the voltage change due to the deflection angle detection section 20 can be made greater.

In detail, it is difficult to increase the value of the capacitance component $C_V$ which is the capacitance component to be detected because the electrodes are formed in a direction perpendicular to the support layer or the like. On the other hand, since the parasitic capacitance caused by the overlap between the Si layer 53 which is an active layer and the Si layer 51 which is a support layer is formed in a direction parallel to the support layer, etc., its value tends to increase. When through holes 80 are not provided, the capacitance component $C_V$ is, for example, about 1 pF, whereas the capacitance component $C_{s-R}$ may be about several tens of pF. In principle, when the ratio of the capacitance component $C_V$ to the capacitance component $C_{s-R}$ ($C_{s-}$

$_R/C_V$) is around 1, amount of voltage change due to the deflection angle detection section 20 reaches its maximum value. As the capacitance component $C_{s-R}$ decreases, the value of $C_{s-R}/C_V$ approaches 1, thereby the amount of voltage change can be made greater.

(Modification example)

Here, note that the present disclosure is not limited to the contents of the embodiments described above, and can be implemented with various modifications within the scope of the appended claims. For example, the resonant driving section in each of the embodiments described above may be used in a non-resonant drive mode, or the non-resonance driving section may be used in a resonant drive mode. Further, in each of the above-described embodiments, cases where a piezoelectric drive type actuator is used have been exemplified, but an antistatic drive type or an electromagnetic drive type actuator may be used. Further, although the capacitance component of the dummy detection section is formed by a comb teeth electrode, it may be formed by a parallel plate electrode. Further, in each of the embodiments described above, two read signal input pads have been provided, but one or three or more pads may be provided instead. Further, the read signal may be applied from the opposite side (movable electrode side). Further, although the shape of each of the through holes 80 and 81 in a plane view is shown as a substantially square shape as one example, it is not limited thereto, and can be formed in various shapes in a plane view, such as a circular, a triangular, or a hexagonal shape. Furthermore, the through holes 80 and 81 do not all have to be the same shape in a plane view, and may include different shapes in a plane view.

**REFERENCE SIGNS LIST**

1: Optical scanning apparatus
2: Reflecting section (Movable mirror)
3: Torsion bar
4: Inner piezoelectric actuator
5: Inner frame section
6: Outer piezoelectric actuator
7: Outer frame section (frame)
13: Piezoelectric Cantilever
15: Driving pad
16: Driving GND pad
17: Groove
20: Deflection angle detection section
20a: Fixed electrode
20b: Movable electrode
20c, 20d: Comb teeth electrode
21: Dummy comb teeth structure section
21a: Fixed electrode
21b: Movable electrode

22: Detection pad
22a: Comb teeth electrode
23: Dummy detection pad
23a: Comb teeth electrode
24: Detection GND pad
24a: Dummy electrode branch
25: Detection GND pad
25a: Comb teeth electrode
26: Comb teeth structure section
27: Dummy detection section
28, 29: Read signal input pad
50: SiO$_2$ layer
51: Si layer
52: SiO$_2$ layer (Box layer)
53: Si layer
54: SiO$_2$ layer
55: Pt layer
56: PZT (lead zirconate titanate) layer
57: Pt layer
80, 81: Through hole

**Claims**

1. An optical scanning apparatus comprising:

   a mirror having a reflective surface;
   a driving section that swings the mirror;
   a detection section that detects the movement of the driving section by change of a capacitance; and
   a dummy capacitance section that generates a dummy capacitance that is approximately equivalent to the capacitance in an initial state of the detection section;
   wherein the detection section has a movable electrode whose position changes in relation to the movement of the driving section and a fixed electrode whose position does not change in relation to the movement of the driving section, and is configured such that the capacitance is generated between the movable electrode and the fixed electrode,
   wherein the dummy capacitance section is configured to include a first electrode and a second electrode, and is configured to generate the dummy capacitance between the first electrode and the second electrode,
   wherein the movable electrode, the fixed electrode, the first electrode, and the second electrode are provided in an active layer formed in the same semiconductor layer, and are each separated,
   wherein the active layer is arranged to face a support layer which is a common semiconductor layer, with an insulating layer in between,
   wherein a first parasitic capacitance that occurs between the active layer provided with the fixed electrode and the supporting layer, and a second parasitic capacitance that occurs between the active layer provided with the first electrode and the supporting layer, are approximately equivalent, and
wherein the capacitance of the detection section and the first parasitic capacitance are connected in series to form a first signal path, and the dummy capacitance and the second parasitic capacitance are connected in series to form a second signal path.

2. The optical scanning apparatus according to claim 1,

wherein the first signal path and the second signal path are connected in parallel, and
wherein the active layer is configured to include a detection pad that can obtain a partial voltage between the capacitance of the detection section and the first parasitic capacitance, and a dummy detection pad that can obtain a partial voltage between the dummy capacitance and the second parasitic capacitance.

3. The optical scanning apparatus according to claim 1 or claim 2,
wherein the support layer has a read signal input pad configured to be exposed on the same side as the reflective surface of the mirror.

4. The optical scanning apparatus according to any one of claims 1 to 3,
wherein the area of the fixed electrode in a plane view and the area of the first electrode in a plane view are approximately equal.

5. The optical scanning apparatus according to any one of claims 1 to 4,
wherein the movable electrode and the fixed electrode each have a comb teeth electrode, and capacitance is generated between these comb teeth electrodes.

6. The optical scanning apparatus according to any one of claims 1 to 5,
wherein the first electrode and the second electrode each have a comb teeth electrode, and dummy capacitance is generated between these comb teeth electrodes.

7. The optical scanning apparatus according to any one of claims 1 to 6,
wherein a read signal is input to the support layer, and a deflection angle of the mirror is determined based on a difference between a partial voltage between the capacitance of the detection section and the first parasitic capacitance, and the partial voltage between the dummy capacitance and the second parasitic capacitance.

8. The optical scanning apparatus according to any one of claims 1 to 7,
wherein the support layer has a plurality of through holes each reaching the insulating layer at a portion related to the generation of each of the first parasitic capacitance and the second parasitic capacitance.

9. An electronic equipment comprising the optical scanning apparatus according to any one of claims 1 to 8.

**Patentansprüche**

1. Optische Abtastvorrichtung, die Folgendes aufweist:

einen Spiegel mit einer reflektierenden Oberfläche;
einen Antriebsabschnitt, der den Spiegel schwenkt;
einen Detektionsabschnitt, der die Bewegung des Antriebsabschnitts durch eine Änderung einer Kapazität erfasst; und
einen Dummy- bzw. Scheinkapazitätsabschnitt, der eine Scheinkapazität erzeugt, die ungefähr der Kapazität in einem Anfangszustand des Detektionsabschnitts entspricht;
wobei der Detektionsabschnitt eine bewegbare Elektrode, deren Position sich in Abhängigkeit von der Bewegung des Antriebsabschnitts ändert, und eine feste Elektrode, deren Position sich in Abhängigkeit von der Bewegung des Antriebsabschnitts nicht ändert, aufweist und so konfiguriert ist, dass die Kapazität zwischen der bewegbaren Elektrode und der festen Elektrode erzeugt wird,
wobei der Scheinkapazitätsabschnitt so konfiguriert ist, dass er eine erste Elektrode und eine zweite Elektrode aufweist, und so konfiguriert ist, dass er die Scheinkapazität zwischen der ersten Elektrode und der zweiten Elektrode erzeugt,
wobei die bewegbare Elektrode, die feste Elektrode, die erste Elektrode und die zweite Elektrode in einer aktiven Schicht vorgesehen sind, die in derselben Halbleiterschicht ausgebildet ist, und voneinander getrennt sind,
wobei die aktive Schicht so angeordnet ist, dass sie zu einer Tragschicht weist, die eine gemeinsame Halbleiterschicht ist, und zwar mit einer dazwischen liegenden Isolierschicht,
wobei eine erste parasitäre Kapazität, die zwischen der mit der festen Elektrode versehenen aktiven Schicht und der Tragschicht auftritt, und eine zweite parasitäre Kapazität, die zwischen der mit der ersten Elektrode versehenen aktiven Schicht und der Tragschicht auftritt, ungefähr gleich sind, und

wobei die Kapazität des Detektionsabschnitts und die erste parasitäre Kapazität in Reihe geschaltet sind, um einen ersten Signalweg zu bilden, und die Dummy- bzw. Scheinkapazität und die zweite parasitäre Kapazität in Reihe geschaltet sind, um einen zweiten Signalweg zu bilden.

2. Optische Abtastvorrichtung nach Anspruch 1,

wobei der erste Signalweg und der zweite Signalweg parallel geschaltet sind, und

wobei die aktive Schicht so konfiguriert ist, dass sie ein Detektionspad, das eine Teilspannung zwischen der Kapazität des Detektionsabschnitts und der ersten parasitären Kapazität erhalten kann, und ein Scheindetektionspad, das eine Teilspannung zwischen der Scheinkapazität und der zweiten parasitären Kapazität erhalten kann, aufweist.

3. Optische Abtastvorrichtung nach Anspruch 1 oder Anspruch 2,

wobei die Tragschicht ein Lesesignaleingangs-Pad aufweist, das so konfiguriert ist, dass es auf derselben Seite wie die reflektierende Oberfläche des Spiegels freiliegt.

4. Optische Abtastvorrichtung nach einem der Ansprüche 1 bis 3,

wobei die Fläche der festen Elektrode in einer Draufsicht und die Fläche der ersten Elektrode in einer Draufsicht ungefähr gleich sind.

5. Optische Abtastvorrichtung nach einem der Ansprüche 1 bis 4,

wobei die bewegbare Elektrode und die feste Elektrode jeweils eine Comb-Teeth- bzw. Kammzahnelektrode aufweisen, und wobei zwischen diesen Kammzahnelektroden eine Kapazität erzeugt wird.

6. Optische Abtastvorrichtung nach einem der Ansprüche 1 bis 5,

wobei die erste Elektrode und die zweite Elektrode jeweils eine Comb-Teeth- bzw. Kammzahnelektrode aufweisen, und wobei zwischen diesen Kammzahnelektroden eine Scheinkapazität erzeugt wird.

7. Optische Abtastvorrichtung nach einem der Ansprüche 1 bis 6,

wobei ein Lesesignal in die Tragschicht eingegeben wird, und wobei ein Auslenkungswinkel des Spiegels auf der Basis einer Differenz zwischen einer Teilspannung zwischen der Kapazität des Detektionsabschnitts und der ersten parasitären Kapazität und der Teilspannung zwischen der Scheinkapazität und der zweiten parasitären Kapazität bestimmt wird.

8. Optische Abtastvorrichtung nach einem der Ansprüche 1 bis 7,

wobei die Tragschicht eine Vielzahl von Durchgangslöchern aufweist, die jeweils die Isolierschicht an einem Abschnitt erreichen, der mit der Erzeugung der ersten parasitären Kapazität und der zweiten parasitären Kapazität in Zusammenhang steht.

9. Elektronisches Gerät, das die optische Abtastvorrichtung gemäß einem der Ansprüche 1 bis 8 aufweist.

**Revendications**

1. Appareil de balayage optique comprenant :

un miroir ayant une surface réfléchissante ;

une section d'entraînement qui fait pivoter le miroir ;

une section de détection qui détecte le mouvement de la section d'entraînement en modifiant une capacité ; et

une section de capacité fictive qui génère une capacité fictive qui est approximativement équivalente à la capacité dans un état initial de la section de détection ;

dans lequel la section de détection a une électrode mobile dont la position change en fonction du mouvement de la section d'entraînement et une électrode fixe dont la position ne change pas en fonction du mouvement de la section d'entraînement, et est configurée de sorte que la capacité soit générée entre l'électrode mobile et l'électrode fixe,

dans lequel la section de capacité fictive est configurée pour inclure une première électrode et une deuxième électrode, et est configurée pour générer la capacité fictive entre la première électrode et la deuxième électrode,

dans lequel l'électrode mobile, l'électrode fixe, la première électrode et la deuxième électrode sont prévues dans une couche active formée dans la même couche semiconductrice, et sont chacune séparées,

dans lequel la couche active est disposée pour faire face à une couche de support qui est une couche semiconductrice commune, avec une couche isolante entre les deux,

dans lequel une première capacité parasite qui apparaît entre la couche active munie de l'électrode fixe et de la couche de support, et une deuxième capacité parasite qui apparaît entre la couche active munie de la première électrode et de la couche de support, sont approximativement équivalentes, et

dans lequel la capacité de la section de détection et la première capacité parasite sont connectées en série pour former un premier chemin de signal, et la capacité fictive et la deuxième capacité parasite sont connectées en série pour former un deuxième chemin de signal.

2. Appareil de balayage optique selon la revendication 1,

dans lequel le premier chemin de signal et le deuxième chemin de signal sont connectés en parallèle, et

dans lequel la couche active est configurée pour inclure un plot de détection qui peut obtenir une tension partielle entre la capacité de la section de détection et la première capacité parasite, et un plot de détection factice qui peut obtenir une tension partielle entre la capacité factice et la deuxième capacité parasite.

3. Appareil de balayage optique selon la revendication 1 ou la revendication 2,
dans lequel la couche de support a un plot d'entrée de signal de lecture configuré pour être exposé du même côté que la surface réfléchissante du miroir.

4. Appareil de balayage optique selon l'une quelconque des revendications 1 à 3,
dans lequel la surface de l'électrode fixe dans une vue en plan et la surface de la première électrode dans une vue en plan sont approximativement égales.

5. Appareil de balayage optique selon l'une quelconque des revendications 1 à 4,
dans lequel l'électrode mobile et l'électrode fixe ont chacune une électrode en dents de peigne, et une capacité est générée entre ces électrodes en dents de peigne.

6. Appareil de balayage optique selon l'une quelconque des revendications 1 à 5,
dans lequel la première électrode et la deuxième électrode ont chacune une électrode en dents de peigne, et une capacité fictive est générée entre ces électrodes en dents de peigne.

7. Appareil de balayage optique selon l'une quelconque des revendications 1 à 6,
dans lequel un signal de lecture est introduit en entrée à la couche de support, et un angle de déviation du miroir est déterminé sur la base d'une différence entre une tension partielle entre la capacité de la section de détection et la première capacité parasite, et la tension partielle entre la capacité fictive et la deuxième capacité parasite.

8. Appareil de balayage optique selon l'une quelconque des revendications 1 à 7,
dans lequel la couche de support a une pluralité d'orifices traversants qui atteignent chacun la couche isolante au niveau d'une partie liée à la génération de chacune parmi la première capacité parasite et la deuxième capacité parasite.

9. Équipement électronique comprenant l'appareil de balayage optique selon l'une quelconque des revendications 1 à 8.

FIG. 1

# FIG. 2A

20b

20d

20c

20a

11   12

# FIG. 2B

21b

21d

21a

## FIG. 3A

24

24a
22a } 26

22

## FIG. 3B

25

25a
23a } 27

23

FIG. 4

15

16

28

25

FIG. 5

FIG. 6

$\underline{1}$

FIG. 7

$\underline{1}$

## FIG. 8A

## FIG. 8B

FIG. 9A

$$V_{in}(t)$$

FIG. 9B

$$V_{out1}(t)$$

FIG. 9C

$$V_{out2}(t)$$

FIG. 9D

90

91

FIG. 10A

54
53
52
51
50

FIG. 10B

55
54

FIG. 10C

56
55

FIG. 10D

57
56

FIG. 10E

57
56

FIG. 10F

55

FIG. 10G

54

FIG. 11A

53

FIG. 11B

52

FIG. 11C

50

FIG. 11D

51

FIG. 11E

51

60

FIG. 11F

52

# FIG. 12

1a

# FIG. 13

FIG. 14

Cd

Cs-L

80

FIG. 15A

53

52

51

80

FIG. 15B

53

52

51

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004245890 A
- JP 2017058418 A
- JP 3011144 B

**Non-patent literature cited in the description**

- **HEE-MOON JEONG et al.** Slow scanning electromagnetic MEMS scanner for laser display. *Proc.SPIE6887, MOEMS and Maniaturized Systems*, 08 February 2008, vol. VII, 688704